# EUROPEAN PATENT APPLICATION

(11) **EP 4 815 709 A1**
(43) Date of publication of application: **30.09.2026**
(21) Application number: 25224087.4
(22) Date of filing: 16.12.2025
(51) Int. Cl.: H10W 20/41, H10D 1/68, H10D 84/80, H10W 20/40, H10D 1/00, H10D 30/00, H10D 30/67

(54) **THROUGH-SUBSTRATE CAPACITOR STRUCTURES IN INTEGRATED CIRCUIT STRUCTURES WITH BACKSIDE METALLIZATION**

(30) Priority: 25.03.2025 US 202519089626
(71) Applicant: INTEL Corporation, Santa Clara, CA 95054 (US)
(72) Inventor: PARK, Changyok, Portland, 97229 (US)
(74) Representative: HGF

(57) **Abstract**

Integrated circuit (IC) dies with through-substrate capacitor (TSC) structures electrically coupled to power rails routed with interconnect metallization that is on a backside of the IC. The capacitor structures can pass power through a thickness of the substrate to circuitry on a front side of the IC die. TSC structures may be fabricated prior to, concurrently with, or subsequent to, the fabrication of transistor structures within adjacent regions of an IC die. TSC structures may be substantially co-planar with transistor structures that utilize a portion of the substrate as channel material. Plates of a TSC structure may be interdigitated laterally or vertically, for example in a comb architecture, with first plates coupled to a first power supply rail (e.g., V_{dd}) spaced from second plates coupled to a second power supply rail (e.g., Vₛₛ) and an electrical insulator therebetween.

## Description

### BACKGROUND

For advanced integrated circuits (ICs), front-side interconnect metallization dimensions continue to scale to smaller dimensions, increasing effective electrical resistance. Introducing back-side interconnect metallization, for example to supply power to transistors, counters the trend of increasing electrical resistance.

IC architectures enabling the integration of more and/or larger capacitors may be advantageous for some applications. For example, the integration of de-coupling capacitors within an IC die can reduce ground bounce during operations of high-performance integrated circuits sensitive to such transients. Capacitor architectures and techniques that can leverage back-side interconnect metallization would therefore be commercially advantageous.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 is a flow diagram illustrating methods of fabricating IC devices including through-substrate capacitor structures coupled with back-side interconnect metallization, in accordance with some embodiments;
FIG. 2, 3, 4, 5, 6 and 7 are cross-sectional views of transistor structures and through-substrate capacitor structures of an IC die evolving as the methods illustrated in FIG. 1 are practiced, in accordance with some embodiments;
FIG. 8 is an isometric view of an IC die structure including a through-substrate capacitor structure, in accordance with some embodiments;
FIG. 9, 10, 11, 12, 13, 14 and 15 are cross-sectional views of transistor structures and through-substrate capacitor structures of an IC die evolving as the methods illustrated in FIG. 1 are practiced, in accordance with some alternative embodiments;
FIG. 16 is an isometric view of an IC die structure including a through-substrate capacitor structure, in accordance with some alternative embodiments;
FIG. 17 illustrates a mobile computing platform and a data server machine employing an IC device including through-substrate capacitor structures, in accordance with some embodiments; and
FIG. 18 is a functional block diagram of an electronic computing device, in accordance with some embodiments.

### DETAILED DESCRIPTION

Embodiments are described with reference to the enclosed figures. While specific configurations and arrangements are depicted and discussed in detail, this is done for illustrative purposes only. Persons skilled in the relevant art will recognize that other configurations and arrangements are possible without departing from the scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct contact with that second material/layer. Similar distinctions are to be made in the context of component assemblies.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. In one example, two compositions that are substantially the same, have only incidental chemical variation. As another example, composition that is substantially a first constituent means the composition may further include <1% of any other constituent. A composition that is substantially first and second constituents means the composition may further include <1% of any constituent substituted for either the first or second constituent.

In accordance with embodiments herein, through-substrate capacitor structures are fabricated within IC die substrate semiconductor material and electrically coupled to power rails routed with backside interconnect metallization. The through-substrate capacitor (TSC) structures may be coupled to power from a back side of an IC die, and feed power through the substrate to circuitry on a front side of the IC die. The TSC structures described herein may offer large electrical capacitance. TSC structures may be fabricated prior to, concurrently with, or subsequent to, the fabrication of transistor structures within adjacent regions of a substrate. TSC structures may be substantially co-planar with transistor structures that utilize a portion of the substrate as channel material. TSC structures can include insulator material to reduce electrical leakage to surround substrate semiconductor material. Alternatively, residual substrate semiconductor material surrounding through-substrate capacitors structures may be removed from an IC die, for example to reduce electrical leakage of the IC die.

In accordance with some embodiments, plates of a TSC structure are interdigitated laterally, with first plates coupled to a first power supply rail (e.g., V_{dd}) spaced from second plates coupled to a second power supply rail (e.g., Vₛₛ) and with an electrical insulator therebetween. In accordance with some alternative embodiments, plates of a TSC structure are interdigitated vertically, with first plates coupled to a first power supply rail (e.g., V_{dd}) and spaced from second plates coupled to a second power supply rail (e.g., Vₛₛ) with an electrical insulator therebetween. Either of these embodiments may be implemented with comb structures or with cylindrical structures, for example as a function of the polygonal shape of a through-substrate via or trench that is etched into the substrate semiconductor. Although comb structures are illustrated herein for the sake of clarity, an application of known techniques can readily implement cylindrical structures in the substantially the same manner described for comb structures.

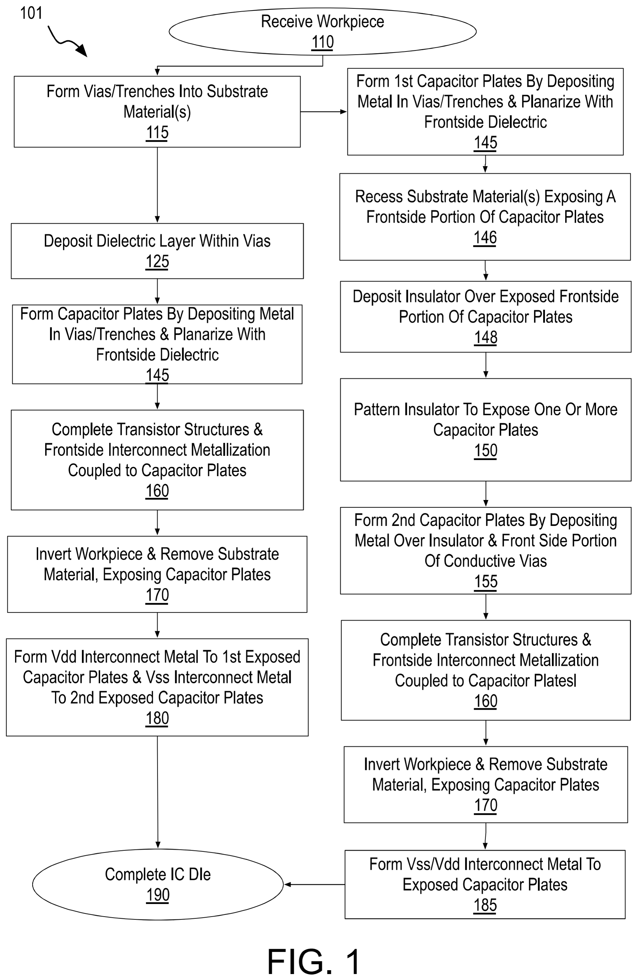

FIG. 1 is a flow diagram illustrating methods 101 for fabricating an IC die, chip, or chiplet with TSC structures coupled to backside interconnect metallization, in accordance with some exemplary embodiments. Methods 101 begin at input 110 with receipt of a workpiece suitable for the fabrication of field effect transistor (FET) structures, or already comprising FET structures. In some examples, the workpiece received at input 110 comprises a 300-450 mm diameter wafer. The workpiece may include a substantially monocrystalline substrate semiconductor material, for example. Following input 110, methods 101 continue at block 115 where a plurality of vias and/or trenches are formed into a TSC region of the substrate semiconductor material, for example with a patterned anisotropic etch process, such as a Bosch-type etch, etc. Each via or trench patterned at block 115 is to define a plate of a capacitor and may be of any polygon shape.

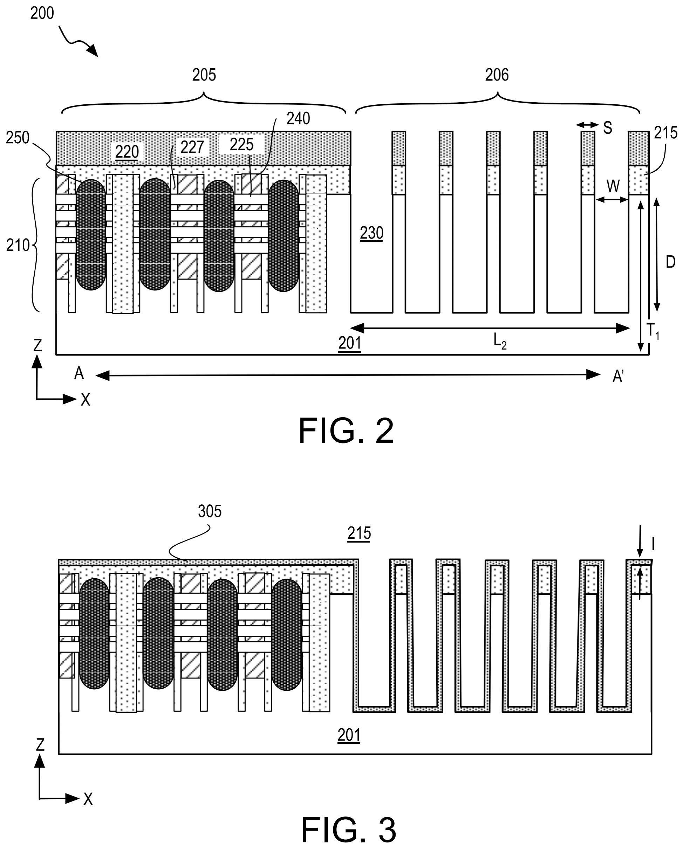

FIG. 2 is a cross-sectional view of an IC die structure 200 including a through-substrate capacitor region 206 following an etch of vias or trenches 230 into a substrate material 201, in accordance with some embodiments. As shown in FIG. 2, each via or trench 230 has a top lateral width W that may vary with implementation. In some exemplary embodiments, top width W is less than 100 nm. For trench embodiments, each trench has a top lateral length L₁ (into page of FIG. 2) exceeding width W. For via embodiments, each via has a top lateral length approximately equal to width W. Each via or trench 230 has a depth D that may vary with implementation, but is generally less than an initial thickness T₁ of substrate material 201, which may be 50-200 µm, or more. In some exemplary embodiments, depth D is 7-25 times width W (e.g., <2.5 µm). Each via or trench 230 may be arrayed over a length L₂ of capacitor region 206, for example as vias in a grid or as trenches in a comb layout, etc. Between adjacent vias/trenches space S may be minimize (e.g., <30 nm) for greater charge capacitance/plate area.

In exemplary embodiments, substrate material 201 is monocrystalline material, such as monocrystalline silicon, monocrystalline germanium, a monocrystalline silicon-germanium alloy, or a monocrystalline III-V material. As further illustrated in FIG. 2, capacitor region 206 is adjacent to a transistor region 205 that may host any transistor structures know to be suitable for IC dies.

One or more material layers may be over substrate material 201. In the example illustrated in FIG. 2, a dielectric material layer 215 is over a front side of substrate material 201 and vias or trenches 230 are patterned through dielectric material layer 215. Dielectric material 215 may have any composition known to be suitable, such as silicon oxides (e.g., SiO₂), silicon nitrides (e.g., Si₃N₄), a silicon oxynitride, (SiON), or a low-k material having a relative permittivity below that of SiO₂, such as SiOCH. Although only one dielectric material layer is illustrated in FIG. 2, dielectric material 215 may comprise two or more material layers having a total thickness, for example in the range of 20-60 nm. One or more layers of mask material 220, such as an organic photoresist or inorganic hardmask, may be utilized as an etch mask to define vias and trenches 230.

In the example further illustrated in FIG. 2, transistor structures 210 fabricated within transistor region 205 comprise vertical stacks of transistor channel material 225. Transistor channel material stacks 225 may be associated with N-type (NMOS) transistor structures and/or P-type (PMOS) transistor structures. Channel material 225 may have any composition suitable for a channel of a field effect transistor (FET) and advantageously has a composition similar to, or substantially the same as, the composition of substrate material 201. In some examples where substrate material 201 is monocrystalline silicon, channel material 225 is also substantially pure silicon. However, in other embodiments where substrate material 201 is monocrystalline silicon, channel material 225 comprises germanium (e.g., SiₓGe_{1-X}, GeₓSn_{1-X}, or substantially pure Ge). In some other embodiments, channel material 225 includes a transition metal and a chalcogen. The transition metal may be any transition metal such as any element of groups 4 through 11, the group 3 elements scandium and yttrium, and the inner transition metals (e.g., f-block lanthanide and actinide series). Notable transition metals are molybdenum and tungsten. The chalcogen may be sulfur, selenium, and tellurium. In still other embodiments, channel material 225 comprises one or more metals and oxygen (i.e., metal oxide semiconductor), such as, but not limited to, Indium, gallium zinc oxide (IGZO).

Channel material 225 is advantageously crystalline. Although the crystalline semiconductor includes polycrystalline thin film material, in some embodiments channel material 225 is substantially monocrystalline. In some embodiments where channel material 225 is substantially pure silicon, the crystallinity of channel material 225 is cubic with a top surface having a crystallographic orientation of (100), (111), or (110). However, other crystallographic orientations are also possible. In other embodiments, channel material 225 may be polycrystalline or amorphous, for example in certain metal chalcogen and/or metal oxide embodiments.

As further illustrated in FIG. 2, a dielectric sidewall spacer dielectric material 227 surrounds underlying channel material 225. Sidewall spacer dielectric material 227 may comprise a silicon-based dielectric (e.g., SiO₂, Si₃N₄, SiON, etc.). Transistor structures 210 further include source and drain semiconductor material 250. PMOS and NMOS source and drain semiconductor material 250 may be separately grown, for example. In some PMOS transistor embodiments, source and drain semiconductor material 250 is a Si₁₋ₓGeₓ alloy further including acceptor impurities imparting p-type electrical conductivity. In some NMOS transistor embodiments, source and drain semiconductor material 250 is substantially pure silicon (i.e., only Group IV element is silicon) further including donor impurities imparting n-type electrical conductivity. Accordingly, except for the greater impurity concentration, source and drain semiconductor material 250 may have substantially the same chemical composition as substrate (semiconductor) material 201. Gate material 240 is adjacent to at least a sidewall of channel material 225 and may further wrap substantially around a nanowire or nanoribbon of channel material 225. Although not illustrated, gate material 240 is electrically coupled to channel material 225 through one or more layers of gate insulator material, which may be any high-k gate dielectric such as HfO₂, Al₂O₃, for example.

Returning to FIG. 1, methods 101 continue either at block 125 for first embodiments or at block 145 for second embodiments. At block 125, an electrical insulator is deposited upon surfaces of the substrate material, lining the vias or trenches patterned at block 115. In the example further illustrated in FIG. 3, mask material 220 has been removed and a dielectric material 305 has been conformally deposited into vias or trenches 230. As shown, the insulator thickness I of dielectric material 305 is sufficient to provide electrical insulation from substrate material 201, but limited to less than one-half of the lateral width W of vias or trenches 230. In some exemplary embodiments where width W is less than 100nm, dielectric material 305 has an insulator thickness I of less than 10 nm. Dielectric material 305 may have any composition known to be a suitable electrical insulator at the chosen insulator thickness I. In some embodiments, dielectric material 305 is a conventional dielectric such as SiO₂, Si₃N₄, or SiON. In other embodiments, dielectric material 305 is a high-k material having a relative permittivity exceeding that of Si₃N₄, such as HfO₂.

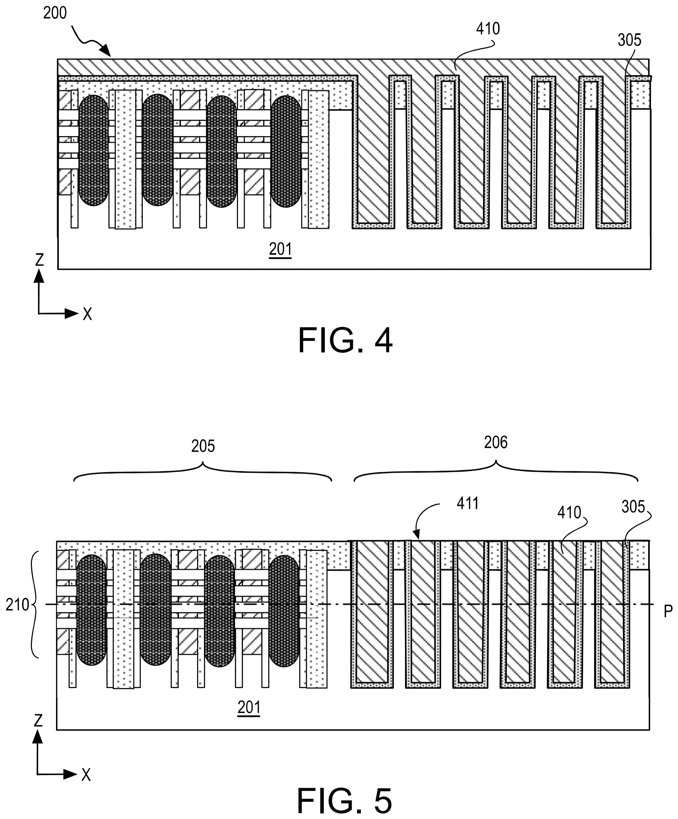

Returning to FIG. 1, methods 101 continue at block 145 where metallization is deposited in the vias or trenches and then planarized with the front side of the substrate material or overlying dielectric material. In the example illustrated in FIG. 4, metallization 410 has been deposited into vias or trenches 230. Although the composition of metallization 410 may vary with implementation, in some examples metallization 410 is predominantly tungsten that may be deposited by chemical vapor deposition or any other technique. In other examples, metallization 410 is predominantly copper or predominantly ruthenium.

As illustrated in FIG. 5, metallization 410 is planarized with dielectric material 215 to form individual conductive plates embedded within a thickness or depth of substrate material 201. Dielectric material 305 remains on all sides of metallization 410 except for top surface 411, thereby insulating each plate from substrate 201. A device layer plane P passing through transistor structure 210 passes through a section of the conductive plates within capacitor region 206. As shown, device layer plane P passes through a longitudinal length of a layer of channel material 225 such that transistor structure 210 is referred to herein as being substantially coplanar with the conductive plates within capacitor region 206. In other words, both transistor structure 210 and conductive capacitor plates are within a same device layer.

Returning to FIG. 1, methods 101 continue at block 160 where frontside interconnect metallization is fabricated to form integrated circuitry according to any known techniques. Frontside interconnect metallization is then fabricated according to any known techniques (e.g., single or dual damascene, etc.). In exemplary embodiments, the frontside interconnect metallization formed at block 160 electrically couples transistor terminals with one or more of the conductive capacitor plates that have been embedded within the substrate.

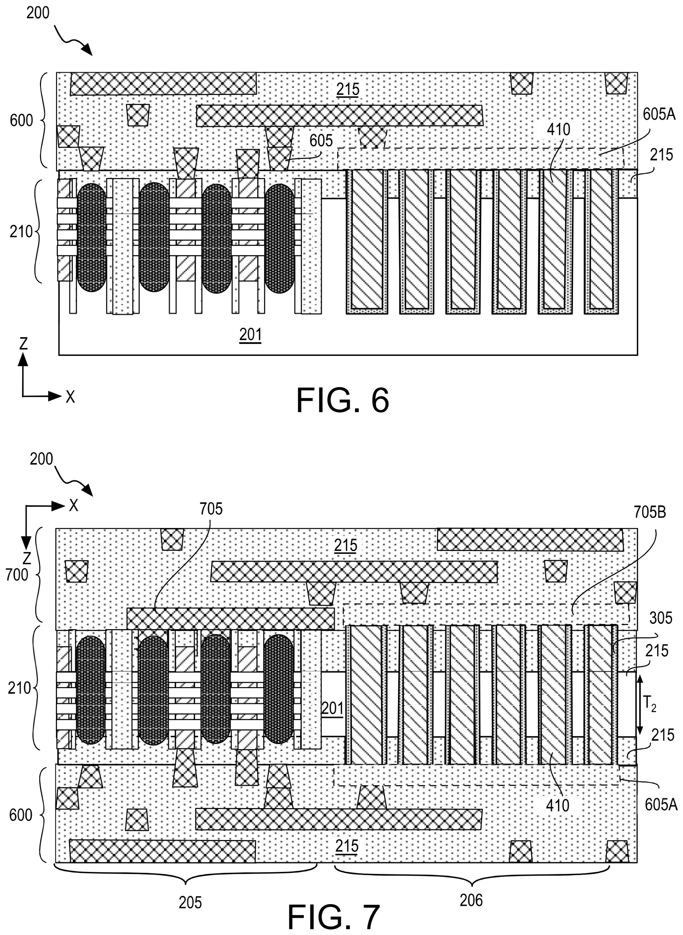

FIG. 6 illustrates an example of frontside interconnect 600, which may comprise any number of levels of frontside metallization features 605 within any thickness of dielectric material 215. As shown, one or more frontside metallization features 605 are electrically coupled with one or more terminals of transistor structures 210. In some embodiments, some frontside metallization features 605 are electrically coupled to at least drain semiconductor material 250 while others may be coupled to gate electrode material 240. As further illustrated, frontside metallization features 605 are also electrically coupled to a subset of the conductive plates of capacitor structure 206. In FIG. 6, frontside metallization features 605 include a capacitor plate interconnect 605A, which is illustrated in dashed line to denote an interconnect line that is behind the plane of the illustrated cross-section and that is in direct contact with metallization 410 of a first subset of capacitor plates. A similar frontside metallization feature (not depicted), for example in front of the plane of the illustrated cross-section, may likewise be in direct contact with metallization 410 of a second subset of capacitor plates. In some embodiments where capacitor plate interconnect 605A is to be powered from a host to a first power supply voltage (e.g., V_{dd}), metallization features 605 further couple (e.g., in electrical parallel) capacitor plate interconnect 605A to drain semiconductor material 250 of one or more transistor structures 210.

Returning to FIG. 1, methods 101 continue at block 170 where the workpiece is inverted and substrate material is removed from a backside of the transistor structures and through-substrate capacitor structures. The substrate material may be thinned with planarization/grinding processes and then further removed with a chemical etch process selective to the composition of the substrate until the a backside of the transistor structures as well as a backside of conductive plates of the capacitor structures are revealed.

At block 180, a backside interconnect metallization structure may be formed in contact with one or more conductive plates of a TSC structure. Backside interconnect metallization may be fabricated according to any known techniques (e.g., single or dual damascene, etc.) as embodiments are not limited in this respect. In exemplary embodiments, fabrication of a backside metallization structure includes the formation of at least a first power rail (e.g., V_{dd}/Vₛₛ) that is in electrical contact with a first plate of a through-substrate capacitor structure. In further embodiments, block 180 further entails the fabrication of a second power rail (e.g., Vₛₛ/V_{dd}) that is in electrical contact with a second plate of the through-substrate capacitor structure. For such embodiments, the through-substrate capacitor structure may pass power supply rails of complementary polarity through the thickness of substrate material remaining after backside processing.

In the example shown in FIG. 7, IC die structure 200 has been inverted for backside processing that includes removal of at least a partial thickness of substrate material 201. In exemplary embodiments where substrate material 201 is silicon, removal of the substrate material may include a silicon selective chemical etch. In the illustrated example, selectivity of the substrate material etch relative to transistor and capacitor structures of a different composition can result in exposing a bottom of source/drain semiconductor material 250 and/or gate electrode 240, and/or a bottom of capacitor plate metallization 410. Substrate material 201 may be thinned to any reduced thickness T₂. In some embodiments, substrate thickness T₂ is non-zero and may be approximately equal to the via/trench depth D that defined capacitor plate metallization 410. For example, substrate thickness T₂ may be less than 2.5 µm. In other embodiments, substrate material 201 is completely removed (i.e., substrate thickness T₂ is zero) and replaced with dielectric material 215.

FIG. 7 further illustrates an example of a backside interconnect metallization structure 700, which may comprise any number of levels of backside metallization features 705 within any thickness of dielectric material 215. As shown, one or more backside metallization features 705 may be electrically coupled with one or more terminals of transistor structures 210. In some embodiments, some backside metallization features 705 are electrically coupled to at least source semiconductor material 250. As further illustrated, backside metallization features 705 (e.g., a line or route) are also electrically coupled to a subset of the conductive plates of a TSC structure within capacitor region 206. In FIG. 7, backside metallization features 705 include a capacitor plate interconnect 705B, which is illustrated in dashed line to denote an interconnect line in front of the plane of the illustrated cross-section and that is in direct contact with metallization 410 of a second subset of capacitor plates. A similar backside metallization feature (not depicted), for example behind the plane of the illustrated cross-section, may likewise be in direct contact with metallization 410 of the first subset of capacitor plates. In some embodiments where capacitor plate interconnect 705B is to be powered by a host at a second power supply voltage (e.g., Vₛₛ), backside interconnect metallization structure 700 further couples (e.g., in electrical parallel) capacitor plate interconnect 705B to drain semiconductor material 250 of one or more of transistor structures 210. Hence, a first power rail (e.g., V_{dd} or Vₛₛ) may be coupled to a first circuit node (e.g., transistor source material) through a first plate of a TSC while a second power rail (e.g., Vₛₛ or V_{dd}) may be similarly coupled in to a second circuit node through the second plate of the TSC. Power applied across the circuit nodes may therefore be conditioned to removed small transients (e.g., ripple or ground bounce) that would otherwise be passed into the transistor structures.

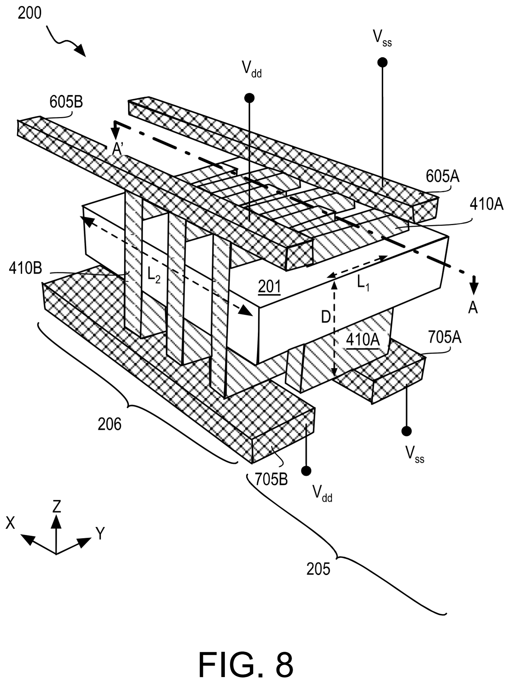

FIG. 8 is an isometric view of IC die structure 200 illustrating a TSC structure within capacitor region 206 with transistor structures in region 205 omitted for clarity. The dashed A-A' line denotes a plane passing through plates of the TSC structure and that is illustrated by the cross-sectional views depicted in FIG. 2-7. As shown in FIG. 8, frontside capacitor plate interconnect 605A is electrically coupled to backside capacitor plate interconnect 705A through first capacitor plates comprising metallization 410A, which may feed a first power supply rail voltage (e.g., Vₛₛ) through substrate material 201. Another frontside capacitor plate interconnect 605B is similarly electrically coupled to a laterally adjacent second backside capacitor plate interconnect 705B through second capacitor plates comprising metallization 410B, which may feed a second power supply rail voltage (e.g., V_{dd}) through substrate material 201. The TSC structure has a lateral comb architecture with capacitor plates 410A interdigitated with capacitor plates 410B over any lateral overlapping length L₁. The capacitive area of capacitor structure 206 is then a function of via/trench depth D, length L₁, and the number of plates arrayed over length L₂.

Returning to FIG. 1, first embodiments of methods 101 end at output 190 with the completion of the IC die fabrication according to any known techniques as embodiments herein are not limited in this respect. IC die may then be singulated from the workpiece, and packaged according to any known techniques. The packaged IC die may then be assembled into a computer system or platform, such as a mobile device or server platform, for example as described further below.

In alternative embodiments, following via/trench definition at block 115, methods 101 proceed to block 145 where first capacitor plates are formed by depositing metal in the vias or trenches formed at block 115. If electrical isolation from the substrate material is a concern, dielectric material may be deposited over the substrate material prior to depositing metal. Metal deposition at block 145 may follow any technique suitable for the metal composition. In some examples, tungsten is deposited with a chemical vapor deposition (CVD) process. In other examples, copper or ruthenium may be deposited at block 145.

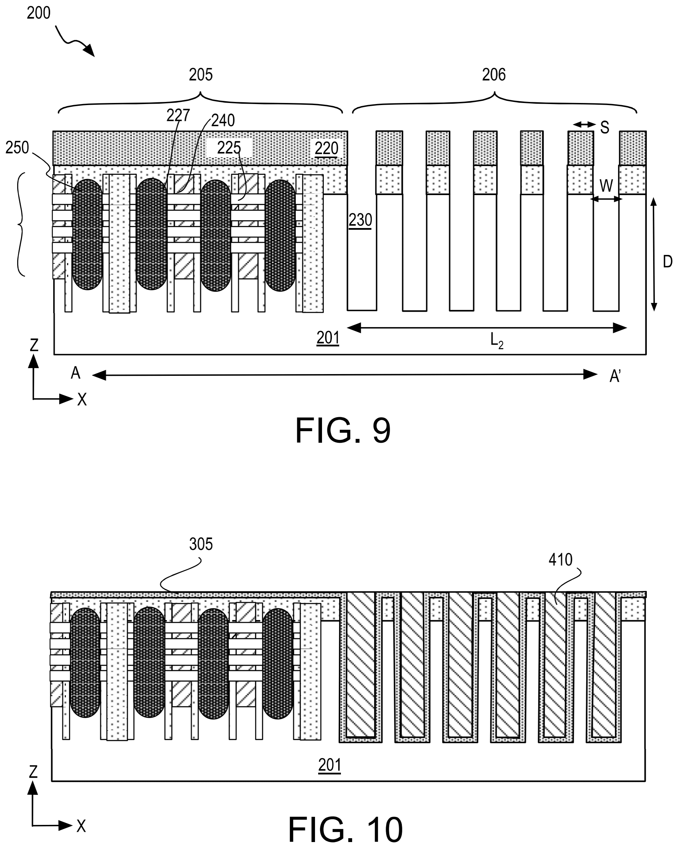

FIG. 9 is a cross-sectional view of IC die structure 200 including transistor region 205 and TSC region 206 following an etch of vias or trenches 230 into a substrate material 201, in accordance with some embodiments. Within transistor regions 205, transistor structures 210 comprise stacks of transistor channel material 225. Transistor channel material stacks 225 may again be associated with N-type (NMOS) transistor structures and/or P-type (PMOS) transistor structures. Channel material 225 may again have any composition suitable for a channel of a field effect transistor (FET) and advantageously has a composition similar to, or substantially the same as, the composition of substrate material 201. In some examples where substrate material 201 is monocrystalline silicon, channel material 225 is also substantially pure silicon. However, channel material 225 may also be of an alternative composition, such as any of those described above.

Channel material 225 is advantageously crystalline. Although the crystalline semiconductor includes polycrystalline thin film material, in some embodiments channel material 225 is substantially monocrystalline. In some examples where channel material 225 is substantially pure silicon, the crystallinity of channel material 225 is cubic with a top surface having a crystallographic orientation of (100), (111), or (110). However, other crystallographic orientations are also possible. In other examples, channel material 225 may be polycrystalline or amorphous, for example in certain metal chalcogen and/or metal oxide embodiments. Transistor structures 210 further include source and drain semiconductor material 250, which may have any composition, such as any of those described above.

Within TSC region 206, each via or trench 230 has a top lateral width W, which may again be less than 100 nm. For trench embodiments, each trench has a top lateral length L₁ (into page of FIG. 2) exceeding width W. For via embodiments, each via has a top lateral length approximately equal to width W. Each via or trench 230 has a depth D that is again less than an initial thickness T₁ of substrate material 201, and may be 7-25 times width W (e.g., <2.5 µm). Each via or trench 230 may be arrayed over a length L₂ of capacitor region 206, for example as vias in a grid or as trenches in a comb layout, etc. For these embodiments, space S between adjacent vias/trenches may be of any dimension sufficient for accommodating subsequent feature fabrication. As further illustrated in FIG. 10, dielectric material 305 and metallization 410 has been deposited into vias or trenches 230 and metallization 410 planarized with dielectric material 305 (or 215) to form individual conductive plates embedded within a thickness or depth of substrate material 201.

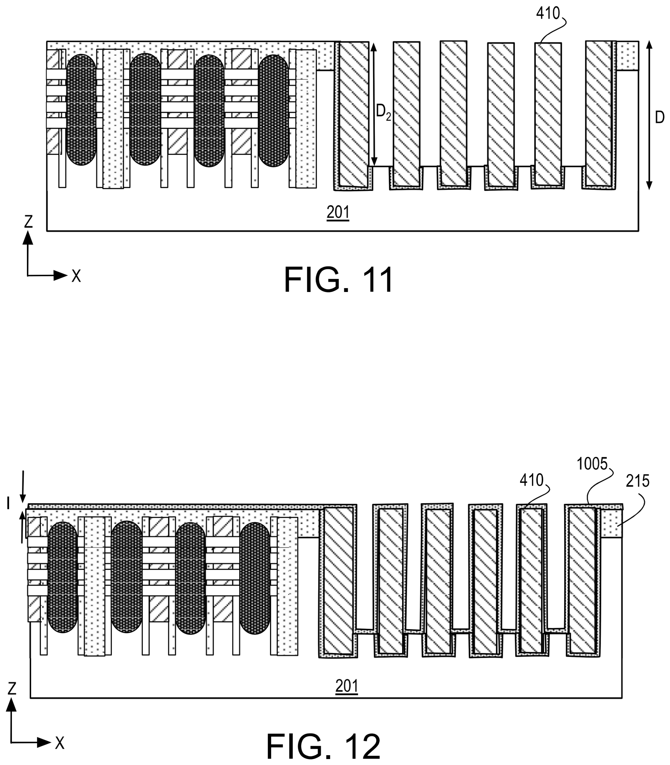

Returning to FIG. 1, methods 101 continue at block 146 where substrate material is recessed with any etch process of suitable selectivity to exposes a frontside portion of the capacitor plates. In some embodiments, the recess etch process is substantially the same as that practiced to define the vias or trenches at block 146. In other embodiments, the recess etch is different than that practiced to define the vias or trenches. For example, a wet etch or other isotropic etch may be practiced at block 146. FIG. 11 illustrates an example where substrate material 201 within capacitor region 206 has been recessed to a depth D₂, which is less than the via/trench depth D. In some embodiments, depth D₂ is at least 50% of depth D and advantageously at least 75% of depth D. Along depth D₂, sidewalls of capacitor plate metallization 410 are exposed.

Methods 101 (FIG. 1) continue at block 148 with the deposition of an insulator over the exposed surfaces of the capacitor plates. Although any deposition process may be practiced at block 148, in some examples a conformal deposition process (e.g., CVD) is employed to form a liner on each capacitor plate. In the example illustrated in FIG. 12 , a dielectric material 1005 has been deposited to an insulator thickness I. Insulator thickness I is limited to less than one-half of the lateral width W of vias or trenches 230. In some exemplary embodiments where width W is less than 100nm, dielectric material 1005 has an insulator thickness I of less than 10 nm. Dielectric material 1005 may have any composition known to be a suitable capacitor insulator at the chosen insulator thickness I. In some embodiments, dielectric material 1005 is a conventional dielectric such as a silicon oxide (e.g., SiO₂), a silicon nitride (e.g., Si₃N₄), or a silicon oxynitride, (SiON). In other embodiments, dielectric material 1005 is a high-k material having a relative permittivity exceeding that of Si₃N₄, such as HfO₂.

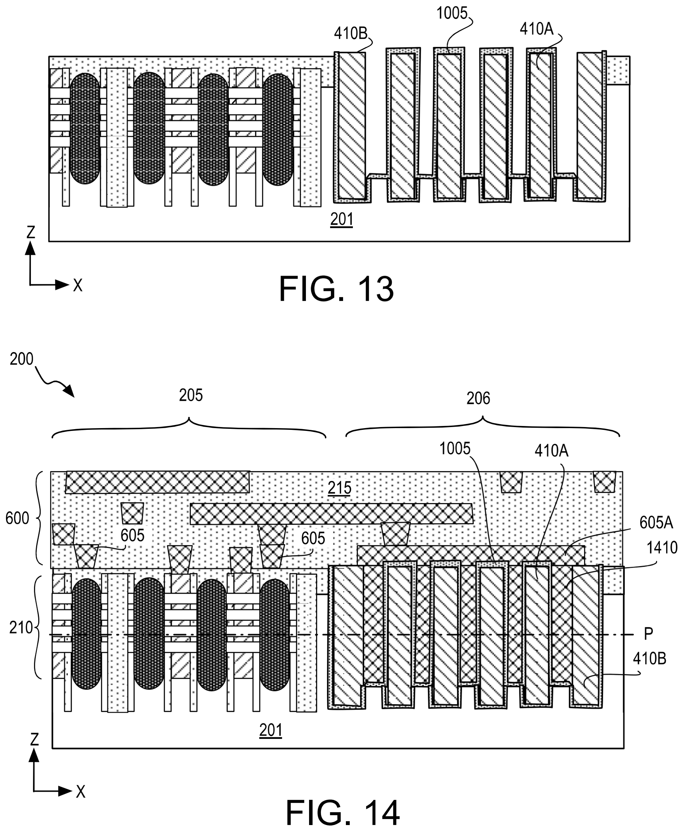

Returning to FIG. 1, methods 101 continue at block 150 where the capacitor insulator is patterned according to any masked etch process suitable for the material compositions present on the workpiece. Patterning of the insulator material exposes at least a portion of at least one of the capacitor plates. In the example illustrated in FIG. 13, dielectric material 1005 has been removed from capacitor plate metallization 410B while dielectric material 1005 has been retained over capacitor plate metallization 410A.

As further illustrated in FIG. 1, methods 101 continue at block 155 where second capacitor plates are formed by depositing a metal over the insulator that was deposited at block 148, thereby forming a metal-insulator-metal (MIM) material stack. Any metal composition may be deposited at block 155 according to any deposition technique known to be suitable for the composition and capable of filling the recesses between the existing capacitor plate metallization.

With a frontside of a TSC structure completed, methods 101 proceed to block 160 where frontside interconnect metallization is fabricated to form integrated circuitry according to any known techniques. In exemplary embodiments, the frontside interconnect metallization formed at block 160 not only electrically couples to terminals of transistor structures, but also electrically couples circuit nodes with one or more of the TSC plates that have been embedded within the substrate.

In the example illustrated in FIG. 14, IC die structure 200 has evolved to include frontside interconnect structure 600 within transistor region 205 and capacitor region 206. Frontside interconnect structure 600 may again comprise any number of levels of frontside metallization features 605 within any thickness of dielectric material 215. In this example, frontside metallization features 605 include a capacitor plate metallization 1410 that fills in the recesses between capacitor plate metallization 410A/410B, and capacitor plate interconnect 605A, which contacts plate metallization 410. In regions where dielectric material 1005 is present, capacitor plate interconnect 605A does not contact capacitor plate metallization 1410. In other regions where dielectric material 1005 is absent, capacitor plate interconnect 605A directly contacts capacitor plate metallization 410B.

In some embodiments where capacitor plate interconnect 605A is to be powered from a host to a first power supply voltage (e.g., V_{dd}), metallization features 605 further couple (e.g., in electrical parallel) capacitor plate interconnect 605A to a first circuit node. As further illustrated in FIG. 14, device layer plane P again passes through a longitudinal length of a layer of channel material 225 such that transistor structure 210 may again be referred to herein as substantially coplanar (i.e., in a plane of the same device layer) with the conductive plates within capacitor region 206.

Returning to FIG. 1, methods 101 continue at block 170 where the workpiece is inverted and substrate material is removed from the back side of the workpiece, which exposes a bottom side of the capacitor plates and may further expose one or more terminals of transistor structures. Substrate material may be thinned with planarization/grinding processes and then further removed with a chemical etch process selective to the composition of the substrate until the a backside of the transistor structures as well as a backside of conductive plates of the capacitor structures are revealed.

At block 185, a backside interconnect metallization structure may be formed in contact with one or more conductive plates of a TSC structure. Backside interconnect metallization may be fabricated according to any known techniques (e.g., single or dual damascene, etc.) as embodiments are not limited in this respect. In exemplary embodiments, fabrication of a backside metallization structure includes the formation of at least a first power rail (e.g., V_{dd}/Vₛₛ) that is in electrical contact with a first plate of a TSC structure. In further embodiments, block 180 further entails the fabrication of a second power rail (e.g., Vₛₛ/N_{dd}) that is in electrical contact with a second plate of the TSC structure. For such embodiments, the through-substrate capacitor structure may pass power supply rails of complementary polarity through the thickness of substrate material remaining after backside processing. Second embodiments of methods 101 then similarly end at output 190, for example substantially as described elsewhere herein.

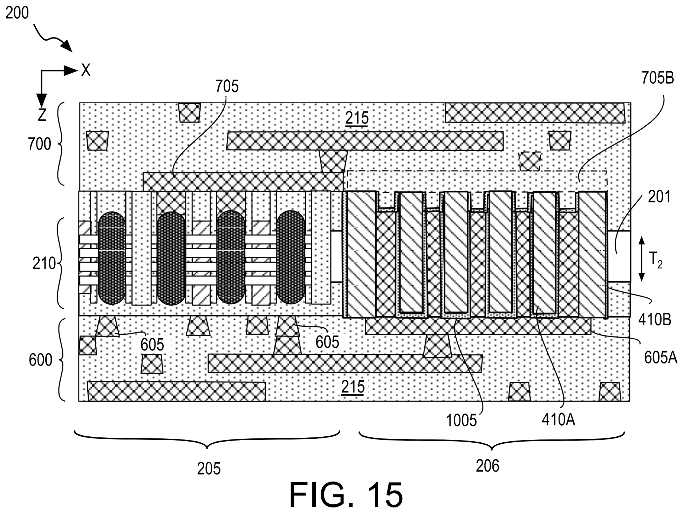

In FIG. 15, IC die structure 200 has been inverted at least a partial thickness of substrate material 201 removed. In exemplary embodiments where substrate material 201 is silicon, removal of the substrate material may again include a silicon selective chemical etch. In the illustrated example, selectivity of the substrate material etch relative to transistor and capacitor structures of a different composition can result in exposing a bottom of source/drain semiconductor material 250 and/or gate electrode 240, and/or a bottom of capacitor plate metallization 410 (e.g., both 410A and 410B). Substrate material 201 may be thinned to any reduced thickness T₂. In some embodiments, substrate thickness T₂ is non-zero and may be approximately equal to the via/trench depth D that defined capacitor plate metallization 410. For example, substrate thickness T₂ may be less than 2.5 µm. In other embodiments, substrate material 201 is completely removed (i.e., substrate thickness T₂ is zero) and replaced with dielectric material 215.

FIG. 15 further illustrates another example of backside interconnect structure 700, which may again comprise any number of levels of backside metallization features 705 within any thickness of dielectric material 215. As shown, one or more backside metallization features 705 may be electrically coupled with one or more terminals of transistor structures 210. In some embodiments, some backside metallization features 705 are electrically coupled to at least source semiconductor material 250. As further illustrated, backside metallization features 705 (e.g., a line or route) are also electrically coupled to a subset of the conductive plates of a through-substrate capacitor structure.

Backside metallization features 705 further includes capacitor plate interconnect 705B, which is illustrated in dashed line to denote an interconnect line or route that is behind the plane of the illustrated cross-section and that is in direct contact with one of capacitor plate metallizations 410A or 410B. A similar backside metallization feature (not depicted), for example in front the plane of the illustrated cross-section, may likewise be in direct contact with only the other one of capacitor plate metallizations 410A or 410B. In some embodiments where capacitor plate interconnect 705B is to be powered by a host at a second power supply voltage (e.g., Vₛₛ), backside interconnect metallization 700 further couples (e.g., in electrical parallel) capacitor plate interconnect 705B to drain semiconductor material 250 of one or more of transistor structures 210. Hence, a first power rail (e.g., V_{dd} or Vₛₛ) may be coupled to a first circuit node (e.g., transistor source material) through a first plate of a through-substrate capacitor while a second power rail (e.g., Vₛₛ or V_{dd}) may be coupled to another circuit node through the second plate of a through-substrate capacitor. Power applied to the circuit nodes may therefore be conditioned to removed small transients (e.g., ripple or ground bounce) that would otherwise be passed into the transistor structures.

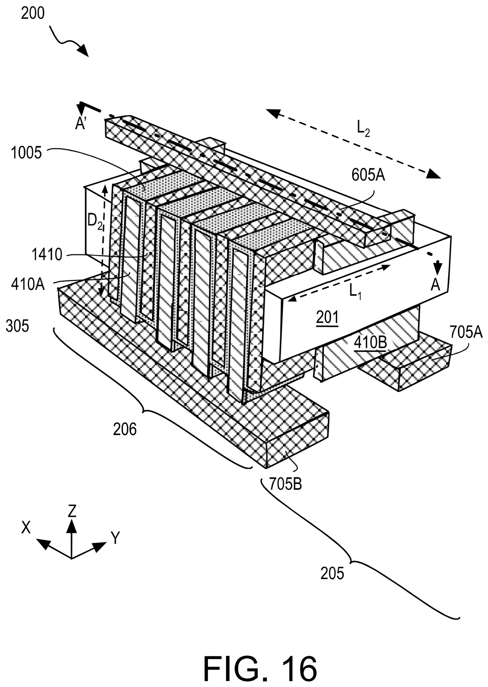

FIG. 16 is an isometric view of IC die structure 200 including a TSC structure within capacitor region 206. Transistor structures in region 205 are omitted for clarity. The dashed A-A' line denotes a plane passing through plates of the through-substrate capacitor structure within capacitor region 206, which is illustrated by the cross-sectional views depicted in FIG. 9-15. As shown in FIG. 16, frontside capacitor plate interconnect 605A is electrically coupled to backside capacitor plate interconnect 705A through first capacitor plates comprising metallization 410B, which may feed a first power supply rail voltage (e.g., Vₛₛ) through substrate material 201. Another frontside capacitor plate interconnect (not depicted) may be electrically coupled to another backside capacitor plate interconnect 705B that is in contact with capacitor plate metallization 410A, and which may feed a second power supply rail voltage (e.g., V_{dd}) through substrate material 201. The TSC structure therefore has a vertical comb architecture with capacitor plate metallization 410A interdigitated with capacitor plate metallization 1410 over any suitable lateral overlapping length L₁. The capacitive area of capacitor structure 206 is then a function of substrate material recess depth D₂, length L₁, and the number of plates arrayed over length L₂.

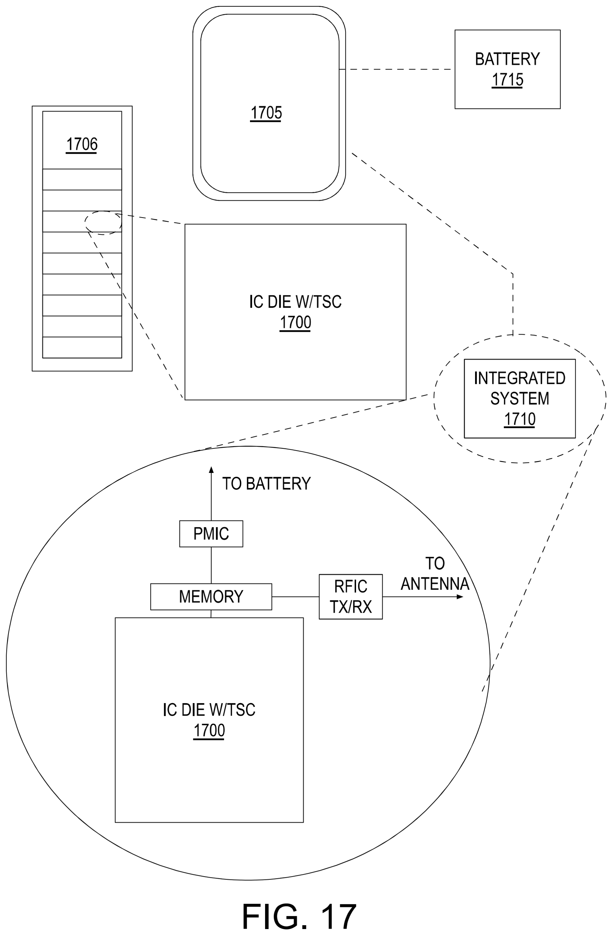

The transistor structures and TSC structures described above may be employed in a wide range of IC devices and further integrated in a wide range of computer-based applications. FIG. 17 illustrates a mobile computing platform 1705 and a server machine 1706, each employing an IC die 1700 comprising transistor structures and TSC structures that are both contacted by backside metallization, for example as described elsewhere herein.

Server machine 1706 may be any commercial server, for example including any number of high-performance computing platforms disposed within a rack and networked together for electronic data processing, which in the exemplary embodiment includes an IC die 1700 comprising transistor structures and through-substrate capacitor structures that are both contacted by backside metallization, for example as described elsewhere herein. The mobile computing platform 1705 may be any portable device configured for each of electronic data display, electronic data processing, wireless electronic data transmission, or the like. For example, the mobile computing platform 1705 may be any of a tablet, a smart phone, laptop computer, etc., and may include a display screen (e.g., a capacitive, inductive, resistive, or optical touchscreen), an integrated system 1710, and a battery 1715.

As illustrated in the expanded view of FIG. 17, one or more of a power management integrated circuit (PMIC) or RF (wireless) integrated circuit (RFIC) including a wideband RF (wireless) transmitter and/or receiver may be further coupled to IC die 1700. A PMIC may perform battery power regulation, DC-to-DC conversion, etc., and so has an input coupled to battery 1715 and an output providing a current supply to other functional modules. An RFIC may have an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G and beyond.

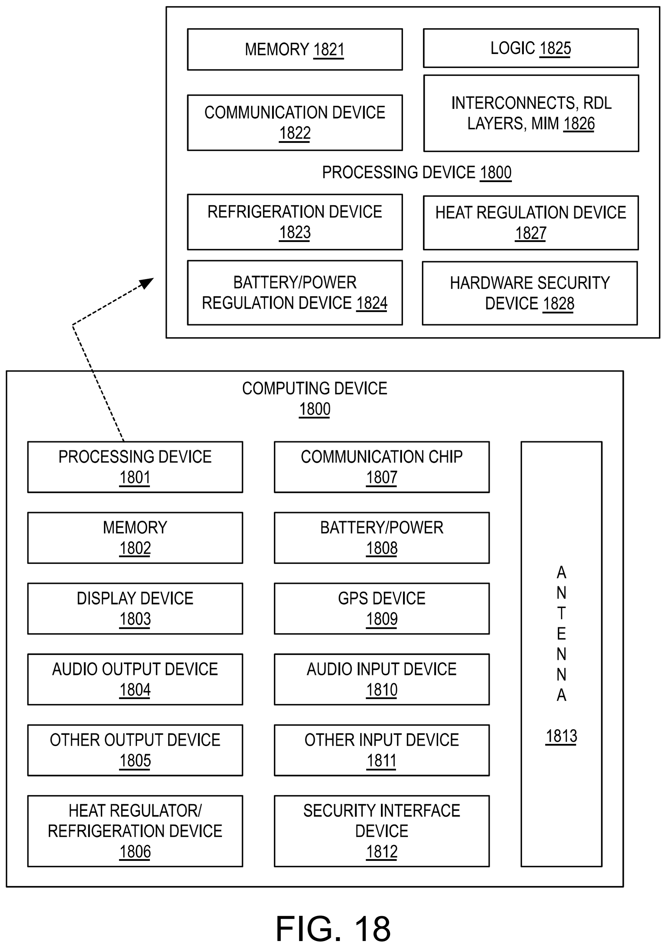

FIG. 18 is a block diagram of a cryogenically cooled computing device 1800 in accordance with some embodiments. For example, one or more components of computing device 1800 may include an IC die comprising transistor structures and through-substrate capacitor structures that are both contacted by backside metallization, for example as described elsewhere herein. A number of components are illustrated in FIG. 18 as included in computing device 1800, but any one or more of these components may be omitted or duplicated, as suitable for the application. In some embodiments, some or all of the components included in computing device 1800 may be attached to one or more printed circuit boards (e.g., a motherboard). In some embodiments, various ones of these components may be fabricated onto a single system-on-a-chip (SoC) die. Additionally, in various embodiments, computing device 1800 may not include one or more of the components illustrated in FIG. 18, but computing device 1800 may include interface circuitry for coupling to the one or more components. For example, computing device 1800 may not include a display device 1803, but may include display device interface circuitry (e.g., a connector and driver circuitry) to which display device 1803 may be coupled.

Computing device 1800 may include a processing device 1801 (e.g., one or more processing devices). As used herein, the term processing device or processor indicates a device that processes electronic data from registers and/or memory to transform that electronic data into other electronic data that may be stored in registers and/or memory. Processing device 1801 may include a memory 1821, a communication device 1822, a refrigeration/active cooling device 1823, a battery/power regulation device 1824, logic 1825, interconnects 1826 (i.e., optionally including redistribution layers (RDL) or metal-insulator-metal (MIM) devices), a heat regulation device 1827, and a hardware security device 1828.

Processing device 1801 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

Processing device 1801 may include a memory 1802, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 1821 includes memory that shares a die with processing device 1801. This memory may be used as cache memory and may include embedded dynamic random-access memory (eDRAM) or spin transfer torque magnetic random-access memory (STT-M RAM).

Computing device 1800 may include a heat regulation/refrigeration device 1806. Heat regulation/refrigeration device 1806 may maintain processing device 1801 (and/or other components of computing device 1800) at a predetermined low temperature during operation. This predetermined low temperature may be any temperature discussed elsewhere herein.

In some embodiments, computing device 1800 may include a communication chip 1807 (e.g., one or more communication chips). For example, the communication chip 1807 may be configured for managing wireless communications for the transfer of data to and from computing device 1800. The term "wireless" and its derivatives may be used to describe circuits, devices, systems, methods, techniques, communications channels, etc., that may communicate data through the use of modulated electromagnetic radiation through a nonsolid medium.

Communication chip 1807 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). Communication chip 1807 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 1807 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 1807 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 1807 may operate in accordance with other wireless protocols in other embodiments. Computing device 1800 may include an antenna 1813 to facilitate wireless communications and/or to receive other wireless communications (such as AM or FM radio transmissions).

In some embodiments, communication chip 1807 may manage wired communications, such as electrical, optical, or any other suitable communication protocols (e.g., the Ethernet). As noted above, communication chip 1807 may include multiple communication chips. For instance, a first communication chip 1807 may be dedicated to shorter-range wireless communications such as Wi-Fi or Bluetooth, and a second communication chip 1807 may be dedicated to longer-range wireless communications such as GPS, EDGE, GPRS, CDMA, WiMAX, LTE, EV-DO, or others. In some embodiments, a first communication chip 1807 may be dedicated to wireless communications, and a second communication chip 1807 may be dedicated to wired communications.

Computing device 1800 may include battery/power circuitry 1808. Battery/power circuitry 1808 may include one or more energy storage devices (e.g., batteries or capacitors) and/or circuitry for coupling components of computing device 1800 to an energy source separate from computing device 1800 (e.g., AC line power).

Computing device 1800 may include a display device 1803 (or corresponding interface circuitry, as discussed above). Display device 1803 may include any visual indicators, such as a heads-up display, a computer monitor, a projector, a touchscreen display, a liquid crystal display (LCD), a light-emitting diode display, or a flat panel display, for example.

Computing device 1800 may include an audio output device 1804 (or corresponding interface circuitry, as discussed above). Audio output device 1804 may include any device that generates an audible indicator, such as speakers, headsets, or earbuds, for example.

Computing device 1800 may include an audio input device 1810 (or corresponding interface circuitry, as discussed above). Audio input device 1810 may include any device that generates a signal representative of a sound, such as microphones, microphone arrays, or digital instruments (e.g., instruments having a musical instrument digital interface (MIDI) output).

Computing device 1800 may include a global positioning system (GPS) device 1809 (or corresponding interface circuitry, as discussed above). GPS device 1809 may be in communication with a satellite-based system and may receive a location of computing device 1800, as known in the art.

Computing device 1800 may include another output device 1805 (or corresponding interface circuitry, as discussed above). Examples include an audio codec, a video codec, a printer, a wired or wireless transmitter for providing information to other devices, or an additional storage device.

Computing device 1800 may include another input device 1811 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 1800 may include a security interface device 1812. Security interface device 1812 may include any device that provides security measures for computing device 1800 such as intrusion detection, biometric validation, security encode or decode, managing access lists, malware detection, or spyware detection. In some examples, security interface device 1812 comprises OTP ROM further including a via MIM fuse, for example as described elsewhere herein.

Computing device 1800, or a subset of its components, may have any appropriate form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the disclosure is not limited to the embodiments described above, but can instead be practiced with modification and alteration without departing from the scope of the appended claims. For example, the above embodiments may include specific combinations of features as further provided below.

In first examples, an integrated circuit (IC) device comprises a device layer comprising a transistor and a capacitor, a first interconnect metallization structure over a frontside of the device layer, and a second interconnect metallization structure over a backside of the device layer. The second interconnect metallization structure comprises a first power supply rail coupled to a first plate of the capacitor a second power supply rail coupled to a second plate of the capacitor.

In second examples, for any of the first examples the transistor further comprises a channel region, and the capacitor comprises a plurality of conductive plates that extend through a plane passing through a longitudinal length of the channel region.

In third examples, for any of the second examples the channel region comprises a semiconductor material and the plurality of conductive plates extend through a substrate comprising the semiconductor material.

In fourth examples, for any of the second through third examples the first interconnect metallization structure comprises a line intersecting a first of the conductive plates.

In fifth examples, for any of the second through fourth examples a first of the conductive plates is electrically coupled to the first power supply rail, and a second of the conductive plates is electrically coupled to the second power supply rail.

In sixth examples, for any of the fifth examples the first power supply rail is further coupled to a source of the transistor.

In seventh examples, for any of the fifth through sixth examples the first of the conductive plates is lined with a dielectric material between a substrate material surrounding the conductive plate and the conductive plate.

In eighth examples, for any of the fifth through seventh examples the first of the conductive plates is one of a plurality of first conductive plates, and the second of the conductive plates is one of a plurality of second conductive plates that are interdigitated with the first conductive plates.

In ninth examples, for any of the eighth examples the plurality of first conductive plates extend a first depth and intersect the first power supply rail, and the plurality of second conductive plates extend the first depth and intersect the second power supply rail.

In tenth examples, for any of the eighth through ninth examples the plurality of first conductive plates extend a first depth and intersect the first power supply rail, the plurality of second conductive plates extend a second depth insufficient to intersect the first power supply rail, and an insulator layer is between adjacent ones of the first and second conductive plates.

In eleventh examples, for any of the tenth examples the second of the conductive plates is electrically coupled to the second power supply rail by a third conductive plate having the first depth and intersecting the second power supply rail.

In twelfth examples a method comprises forming a plurality of vias or trenches into a substrate material, forming a plurality of conductive plates by depositing metal within the vias or trenches, forming a transistor structure adjacent to the conductive plates, forming frontside interconnect metallization on a first side of the transistor structure and coupled to at least a first of the conductive plates, and forming a backside interconnect metallization on a second side of the transistor structure and coupled to at least a second of the conductive plates. Forming the backside interconnect metallization comprises forming a first route electrically coupled to a first subset of the conductive plates, and forming a second route adjacent to the first route and electrically coupled to a second subset of the conductive plates.

In thirteenth examples, for any of the twelfth examples the substrate material is a monocrystalline material comprising silicon, and forming the transistor structure comprises forming a channel region from the substrate material.

In fourteenth examples, for any of the twelfth through thirteenth examples forming the backside interconnect metallization comprises exposing a bottom of one or more of the conductive plates by removing a partial thickness of the substrate material.

In fifteenth examples, for any of the twelfth through fourteenth examples forming the transistor structure further comprises forming a stack of channel regions, each of the channel regions are coplanar with a section of the conductive plates.

In sixteenth examples, for any of the twelfth through fifteenth examples forming the plurality of conductive plates comprises forming an array of trenches of substantially the same length, width and depth.

In seventeenth examples, a method, comprises forming a first plurality of vias or trenches into a substrate material, forming first conductive plates by depositing a metal within the first plurality of vias or trenches, recessing the substrate material exposing a portion of the first conductive plates, depositing an insulator over the portion of the first conductive plates, forming a second plurality of electrically conductive plates by depositing a metal over the insulator and between adjacent portions of the first conductive plates, forming a transistor structure adjacent to the first and second conductive plates, forming frontside interconnect metallization route on a first side of the transistor structure and coupled to at least some of the second conductive plates, and forming a backside interconnect metallization route on a second side of the transistor structure and coupled to at least some of the first conductive plates.

In eighteenth examples, for any of the seventeenth examples the method further comprises patterning the insulator to expose a first of the first conductive plates, coupling a first of the second plurality of electrically conductive plates to the first of the first conductive plates with metal deposited during the forming of the second plurality of conductive plates, and forming a second backside interconnect metallization route coupled to the first of the first conductive plates.

In nineteenth examples, for any of the eighteenth examples forming the backside interconnect metallization route coupled to at least some of the first conductive plates further comprises exposing a bottom of the first conductive plates by removing from a partial thickness of the substrate material

In twentieth examples, for any of the eighteenth through nineteenth examples forming the first plurality of conductive plates comprises forming an array of trenches of substantially the same length, width and depth.

However, the above embodiments are not limited in this regard, and, in various implementations, the above embodiments may include the undertaking of only a subset of such features, undertaking a different order of such features, undertaking a different combination of such features, and/or undertaking additional features than those features explicitly listed. The scope of the disclosure should, therefore, be determined with reference to the appended claims, along with the full scope of equivalents to which such claims are entitled.

## Claims

1. An integrated circuit, IC, device, comprising:
a device layer comprising a transistor and a capacitor;
a first interconnect metallization structure over a frontside of the device layer; and
a second interconnect metallization structure over a backside of the device layer, wherein the second interconnect metallization structure comprises:
a first power supply rail coupled to a first plate of the capacitor; and
a second power supply rail coupled to a second plate of the capacitor.

2. The IC device of claim 1, wherein:
the transistor further comprises a channel region; and
the capacitor comprises a plurality of conductive plates that extend through a plane passing through a longitudinal length of the channel region.

3. The IC device of claim 2, wherein the channel region comprises a semiconductor material and the plurality of conductive plates extend through a substrate comprising the semiconductor material.

4. The IC device of claim 2, wherein the first interconnect metallization structure comprises a line intersecting a first of the conductive plates.

5. The IC device of any one of claims 2-4, wherein:
a first of the conductive plates is electrically coupled to the first power supply rail; and
a second of the conductive plates is electrically coupled to the second power supply rail.

6. The IC device of claim 5, wherein the first power supply rail is further coupled to a source of the transistor.

7. The IC device of claim 5, wherein the first of the conductive plates is lined with a dielectric material between a substrate material surrounding the conductive plate and the conductive plate.

8. The IC device of claim 5, wherein:
the first of the conductive plates is one of a plurality of first conductive plates; and
the second of the conductive plates is one of a plurality of second conductive plates that are interdigitated with the first conductive plates.

9. The IC device of claim 8, wherein:
the plurality of first conductive plates extend a first depth and intersect the first power supply rail; and
the plurality of second conductive plates extend the first depth and intersect the second power supply rail.

10. The IC device of claim 8, wherein:
the plurality of first conductive plates extend a first depth and intersect the first power supply rail;
the plurality of second conductive plates extend a second depth insufficient to intersect the first power supply rail; and
an insulator layer is between adjacent ones of the first and second conductive plates.

11. The IC device of claim 10, wherein the second of the conductive plates is electrically coupled to the second power supply rail by a third conductive plate having the first depth and intersecting the second power supply rail.

12. A method, comprising:
forming a plurality of vias or trenches into a substrate material;
forming a plurality of conductive plates by depositing metal within the vias or trenches;
forming a transistor structure adjacent to the conductive plates;
forming frontside interconnect metallization on a first side of the transistor structure and coupled to at least a first of the conductive plates; and
forming a backside interconnect metallization on a second side of the transistor structure and coupled to at least a second of the conductive plates, wherein forming the backside interconnect metallization comprises:
forming a first route electrically coupled to a first subset of the conductive plates; and
forming a second route adjacent to the first route and electrically coupled to a second subset of the conductive plates.

13. The method of claim 12, wherein:
the substrate material is a monocrystalline material comprising silicon; and
forming the transistor structure comprises forming a channel region from the substrate material.

14. The method of claim 12, wherein forming the backside interconnect metallization comprises exposing a bottom of one or more of the conductive plates by removing a partial thickness of the substrate material.

15. The method of any one of claims 12-14, wherein:
forming the transistor structure further comprises forming a stack of channel regions, each of the channel regions are coplanar with a section of the conductive plates; and
forming the plurality of conductive plates comprises forming an array of trenches of substantially the same length, width and depth.
